# EUROPEAN PATENT APPLICATION

(11) **EP 2 704 151 A2**
(43) Date of publication of application: **05.03.2014**
(21) Application number: 13178173.4
(22) Date of filing: 26.07.2013
(51) Int. Cl.: G11C 29/26, G11C 29/30

(54) **Semiconductor device and memory test method**

(30) Priority: 31.08.2012 JP 2012192638
(71) Applicant: FUJITSU LIMITED, Kawasaki-shi, Kanagawa 211-8588 (JP); Fujitsu Semiconductor Limited, Kohoku-ku, Yokohama-shi Kanagawa 222-0033 (JP)
(72) Inventor: Yamanaka, Hitoshi, Kanagawa 211-8588 (JP); Gomi, Kenichi, Kanagawa 222-0033 (JP)
(74) Representative: HOFFMANN EITLE

(57) **Abstract**

A RAM-BIST pattern generating unit 1 generates a memory address corresponding to a way of the L2 cache 2, a test pattern, and an expected value with respect to the test pattern. The L2 cache 2 and an XOR circuit 3 write the test pattern to a memory address in accordance with the test pattern, read data from the memory address to which the test pattern is written, and compares the read data with the expected value. A decode unit 5 generates a selection signal for each way of the L2 cache 2 by using a memory address. A determination latch 60 to 67 stores, by using a selection signal and in a way corresponding to each memory address, a comparison result with respect to the memory address, a scan-out being performed on the comparison result stored in each of the ways in a predetermined order.

## Description

### FIELD

The embodiment discussed herein is directed to a semiconductor device and a memory test method.

### BACKGROUND

To achieve high-speed operations, recent CPUs have been provided with a Level 2 (L2) cache, or the like, that is a semiconductor memory. Even if part of an L2 cache is faulty, the L2 cache can still be provided as a product. Therefore, the degree of failure of an L2 cache is determined before shipment, and it is decided whether the L2 cache can be shipped or not.

The capacity of a cache memory is represented by the product of the number of entries and the level of associativity of the cache. The level of associativity is also called the number of ways. A single way has a certain address range. In a single way, data can be stored in different addresses that are indicated by indexes.

In a test to determine the quality of a semiconductor device, such as an L2 cache, the L2 cache is tested, for example, on a per section basis, e.g., on a per way basis. When an entire L2 cache is tested conventionally, the test is conducted the same number of times as there are ways in the L2 cache. For instance, if an L2 cache has 24 ways, the test is conducted 24 times. To facilitate such testing, a conventional technique called a random access memory built-in self-test (RAM-BIST) is used, whereby testing is conducted by using a test pattern generator or a comparator embedded in a chip. Furthermore, to ensure the quality of semiconductors, an at-speed test, or the like, is conducted, whereby a RAM-BIST is performed at the actual speed of the system.

Japanese Laid-open Patent Publication No. 2010-40085

Conventionally, a single memory has a single way. In recent years, however, it has become possible, by dividing the address range of a single memory, to set multiple ways for the single memory.

In conventional test methods for semiconductor devices, however, a case where a single memory corresponds to a single way is assumed, and a case where multiple ways are set for a single memory is not considered. If a conventional test method for semiconductor devices is simply applied to a memory for which multiple ways are set, the test can be conducted on a per way basis; however, the test has to be performed the same number of times as there are ways, which results in a longer test time.

Accordingly, it is an object in one aspect of an embodiment of the invention to provide a semiconductor device and a memory test method whereby a memory is tested in a shorter period of time.

### SUMMARY

According to an aspect of an embodiment, a semiconductor device includes; a memory that is used by dividing an address range into sets of a predetermined number of ways; a test information generating unit that, in order to test the memory, generates a memory address corresponding to the way, a test pattern, and an expected value with respect to the test pattern; a quality determination testing unit that, in accordance with the test pattern, writes the test pattern to the memory address generated by the test information generating unit, reads data from the memory address to which the test pattern is written, and compares the read data with the expected value; a selection signal generating unit that generates a selection signal for each way of the memory by using the memory address generated by the test information generating unit; and a first storage unit that stores, by using the selection signal and in the way corresponding to each memory address, a comparison result obtained by the quality determination testing unit with respect to the memory address, a scan-out being performed on the comparison result stored in each of the ways in a predetermined order.

### BRIEF DESCRIPTION OF DRAWINGS

FIG. 1 is a block diagram of a semiconductor device according to an embodiment;
FIG. 2 is an exemplary diagram that illustrates the values stored in each determination latch;
FIG. 3 is a timing chart of scans and tests;
FIG. 4 is a diagram that illustrates the details of information reading;
FIG. 5 is a diagram that illustrates the relation between each way and the status of each way determined by a tester;
FIG. 6 is a flowchart of a test performed by the semiconductor device according to the embodiment;
FIG. 7 is a flowchart of a process to determine a faulty way; and
FIG. 8 is a hardware configuration diagram of a CPU in which a semiconductor device according to the embodiment is installed.

### DESCRIPTION OF EMBODIMENTS

Preferred embodiments of the present invention will be explained with reference to accompanying drawings The semiconductor device and the memory test method disclosed in the present application are not limited to the following embodiment.

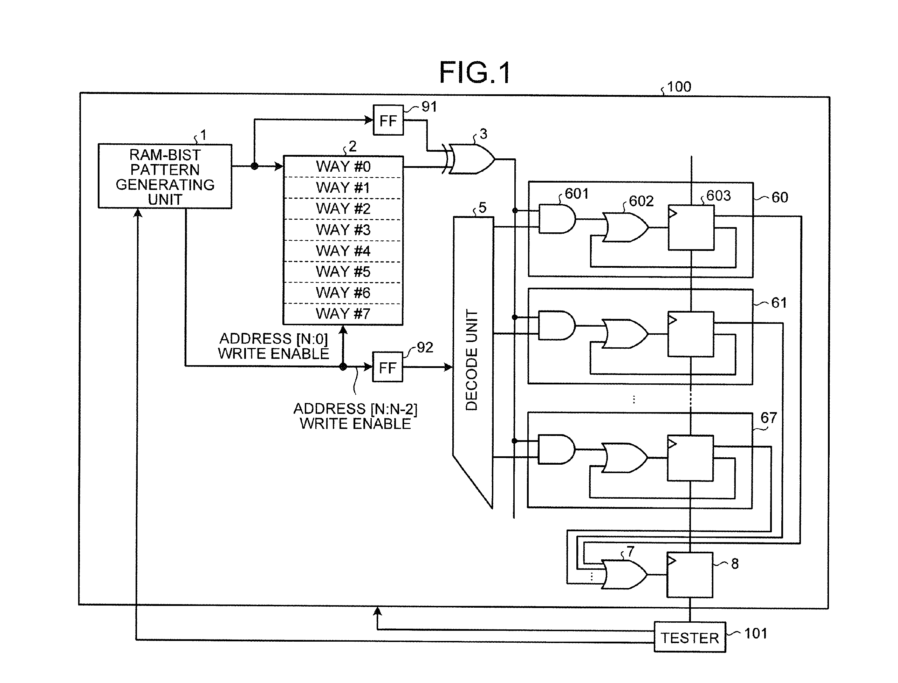

FIG. 1 is a block diagram of a semiconductor device according to an embodiment. As illustrated in FIG. 1, a semiconductor device 100 includes a RAM-BIST pattern generating unit 1, an L2 cache 2, an XOR circuit 3, a decode unit 5, determination latches 60 to 67, an OR circuit 7, and a start-marker 8. The semiconductor device 100 further includes FFs (Flip Flops) 91 and 92. When a test is conducted, the semiconductor device 100 is connected to a tester 101. The tester 101 is a test device that performs an operation test, shipment test, or the like, on the semiconductor device 100. An explanation is given below of an operation performed when the semiconductor device 100 is tested.

The L2 cache 2 has a memory that is used by dividing an address range into sets of a predetermined number of ways. In the present embodiment, an explanation is given of, for example, a case where one memory is divided into 8 ways, i.e., the ways #0 to #7.

First, the RAM-BIST pattern generating unit 1, the L2 cache 2, the XOR circuit 3, the determination latches 60 to 67, and the FFs 91, 92 operate according to a system clock input from the tester 101. For ease of explanation, FIG. 1 omits the line that indicates a system clock that is generated and delivered within the semiconductor device 100 according to a clock input from the tester 101. In addition, the line that indicates a scan clock input from the tester 101 to the semiconductor device 100 is omitted.

The RAM-BIST pattern generating unit 1 receives, from the tester 101, test programs, such as setting information for a test pattern, for example, setting information that indicates the type of test pattern. The test pattern is, for example, a March test. On the basis of the received setting information, the RAM-BIST pattern generating unit 1 generates a test pattern for a memory address on which a quality determination is to be conducted.

In accordance with the test pattern, the RAM-BIST pattern generating unit 1 outputs, to the L2 cache 2 and the FF 92, the memory address, on which a quality determination is to be conducted, and outputs a memory read/write control signal (the "write enable" signal in FIG.1). An explanation is given below by using, for example, a given memory address (hereafter referred to as the "to-be-tested memory address") that is a target for a quality determination.

The RAM-BIST pattern generating unit 1 also outputs the generated test pattern to the L2 cache 2 and the FF 91.

The XOR circuit 3 outputs the result of an exclusive-OR operation using data read from the L2 cache 2 and a test pattern delayed one cycle by the FF 91. Here, data output from the FF 91 is obtained by delaying a test pattern output from the RAM-BIST pattern generating unit 1 by one cycle, the data being an expected value with respect to a result read from the L2 cache 2.

The FF 91 receives an input of an expected value from the RAM-BIST pattern generating unit 1. The FF 91 then delays the received data by the time it takes to read data from the L2 cache 2. The FF 91 outputs the delayed data to the XOR circuit 3.

The XOR circuit 3 receives an input of data read from the to-be-tested memory address of the L2 cache 2. Furthermore, the XOR circuit 3 receives an input of an expected value from the FF 91.

The XOR circuit 3 performs an exclusive OR operation on the received expected value and the data read from the to-be-tested memory address. For example, if the expected value is Low (hereafter, simply referred to as "L") and if the data read from the to-be-tested memory address is High (hereafter, simply referred to as "H"), the XOR circuit 3 outputs a value indicating a mismatch, e.g., "H" to each of the determination latches 60 to 67. Specifically, in the present embodiment, if the expected value is different from the data read from the to-be-tested memory address, the XOR circuit 3 outputs "H" to each of the determination latches 60 to 67. Furthermore, if the expected value is, for example, "L" and the data read from the to-be-tested memory address is also "L", the XOR circuit 3 outputs a value indicating a match, e.g., "L" to each of the determination latches 60 to 67. Specifically, in the present embodiment, if the expected value matches the data read from the to-be-tested memory address, the XOR circuit 3 outputs "L" to each of the determination latches 60 to 67.

The FF 92 receives an input of the to-be-tested memory address from the RAM-BIST pattern generating unit 1. The FF 92 then delays the high-order bits [N:N-2] of the received to-be-tested memory address and the write enable signal by one cycle of a system clock so that the time when data is input from the XOR circuit 3 to an after-mentioned AND circuit 601 coincides with the time when data is input from the decode unit 5 to the after-mentioned AND circuit 601. The FF 92 outputs the delayed to-be-tested memory address and write enable signal to the decode unit 5.

The decode unit 5 receives an input of the to-be-tested memory address and the write enable signal from the FF 92. The decode unit 5 then decodes the received to-be-tested memory address and the received write enable signal. The decode unit 5 then outputs a control signal for storing the result of a comparison performed by the XOR circuit 3 to a determination latch, the determination latch corresponding to the address for which an expected-value comparison is made by the XOR circuit 3 during the reading test.

In the present embodiment, for example, 3 bits [N:N-2] of the memory address indicate any one of the 8 ways. If an expected value is different from data read from the to-be-tested memory address, the XOR circuit 3 outputs "H". If an expected value matches data read from the to-be-tested memory address, the XOR circuit 3 outputs "L". The decode unit 5 acquires 3 bits [N:N-2] of the received to-be-tested memory address and the write enable signal. When the write enable is off, i.e., when reading is performed, the decode unit 5 decodes the acquired 3 bits so as to convert them into information that indicates any one of the ways #0 to #7 in the memory. Conversely, when the write enable is on, i.e., when writing is performed, the 8 outputs of the decode unit 5 are all 0. During reading, the decode unit 5 stores the result of a comparison performed by the XOR circuit 3 in a determination latch that corresponds to the way indicated by the to-be-tested memory address among the determination latches 60 to 67. The previous states of the determination latches of the other ways are maintained by an OR circuit 602.

Out of the determination latches 60 to 67, only three determination latches are illustrated in FIG. 1; however, the same number of determination latches as the number of the ways included in the memory is actually installed. In the present embodiment, for example, the memory includes 8 ways and therefore 8 determination latches 60 to 67 are installed. One of the determination latches 60 to 67 corresponds to one of the 8 ways, i.e., the ways #0 to #7 in the memory. For example, the determination latch 60 corresponds to the way #7, the determination latch 61 corresponds to the way #6, and the determination latch 67 corresponds to the way #0. Each of the determination latches 60 to 67 has the same configuration and the same functionality; therefore, an explanation is given below by using only the determination latch 60 as an example.

The determination latch 60 includes the AND circuit 601, the OR circuit 602, and an FF 603.

The AND circuit 601 receives an input from the XOR circuit 3 and the decode unit 5. The AND circuit 601 performs an AND operation on an input from the XOR circuit 3 and an input from the decode unit 5 and then outputs the obtained result to the OR circuit 602.

For example, assume that an expected value is different from data read from the to-be-tested memory address, and the XOR circuit 3 outputs "H". Furthermore, assume that the way corresponding to the to-be-tested memory address is the way #0, and the decode unit 5 outputs "H" to the determination latch 60 and outputs "L" to the determination latches 61 to 67. At this point, the AND circuit 601 receives an input of "H" from the XOR circuit 3 and receives an input of "H" from the decode unit 5. The AND circuit 601 then outputs "H".

Conversely, assume that, for example, an expected value matches data read from the to-be-tested memory address, and the XOR circuit 3 outputs "L". Furthermore, assume that the way corresponding to the to-be-tested memory address is the way #0, and the decode unit 5 outputs "H" to the determination latch 60 and outputs "L" to the determination latches 61 to 67. At this point, the AND circuit 601 receives an input of "L" from the XOR circuit 3 and receives an input of "H" from the decode unit 5. In this case, the AND circuit 601 outputs "L" regardless of the output of the decode unit 5.

Conversely, assumed that, for example, the way corresponding to the to-be-tested memory address is not the way #0 and the decode unit 5 outputs "L" to the determination latch 60. In this case, the AND circuit 601 always outputs "L". Specifically, the AND circuit 601 outputs "L" to a store latch that corresponds to a way other than the way corresponding to the to-be-tested memory address.

In short, according to the present embodiment, the AND circuit 601 outputs "H" to the OR circuit 602 only if an expected value is different from data read from the to-be-tested memory address and if the way corresponding to the to-be-tested memory address is the way #0. Otherwise, the AND circuit 601 outputs "L" to the OR circuit 602.

The OR circuit 602 receives an input from the AND circuit 601. Furthermore, the OR circuit 602 receives an input from the FF 603. The OR circuit 602 then performs a logical OR operation on the input from the AND circuit 601 and the input from the FF 603 and then outputs the obtained result to the FF 603.

Specifically, the OR circuit 602 receives an input of "H" from the AND circuit 601 only if an expected value is different from data read from the to-be-tested memory address and if the way corresponding to the to-be-tested memory address is the way #0. Otherwise, the OR circuit 602 receives an input of "L" from the AND circuit 601. Moreover, the OR circuit 602 receives an input of "H" from the FF 603 if the OR circuit 602 has already output "H" to the FF 603. Otherwise, the OR circuit 602 receives an input of "L" from the FF 603. If the OR circuit 602 has already input "H" to the FF 603, i.e., if it has been already determined that data read from the way #0 is different from an expected value, the OR circuit 602 receives an input of "H" from the FF 603. In this case, the OR circuit 602 always outputs "H" to the FF 603.

Conversely, if the OR circuit 602 has not input "H" to the FF 603 yet, i.e., if it has not been determined that data read from the way #0 is different from an expected value, the OR circuit 602 receives an input of "L" from the FF 603. In this case, if the input from the AND circuit 601 is "H", i.e., if data read from the way #0 is different from an expected value, the OR circuit 602 outputs "H" to the FF 603. Conversely, if data read from the way #0 matches an expected value or if the way corresponding to the to-be-tested memory address is other than the way #0, the OR circuit 602 receives an input of "L" from the AND circuit 601. At this point, the OR circuit 602 outputs "L" to the FF 603.

In short, if data read from the way #0 matches an expected value, the OR circuit 602 continuously outputs "L" to the FF 603. Conversely, if data read from the way #0 is different from an expected value, then the OR circuit 602 continuously outputs "H" to the FF 603.

The FF 603 receives an input from the OR circuit 602. The FF 603 is held at the received value until the OR circuit 602 receives a subsequent input from the AND circuit 601. The FF 603 outputs the held value to the OR circuit 602 when the OR circuit 602 receives an input from the AND circuit 601.

Thus, the FF 603 is continuously held at "L" if data read from the way #0 matches an expected value. Conversely, if data read from the way #0 is different from an expected value, then the FF 603 is continuously held at "H".

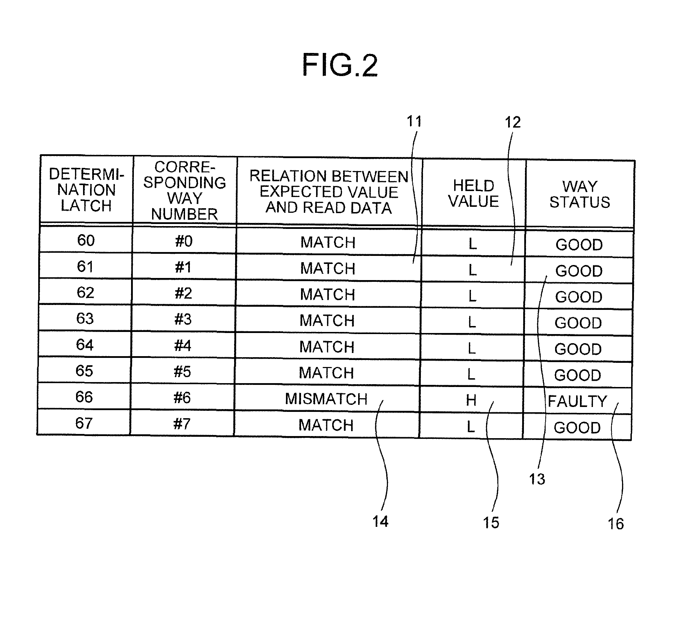

FIG. 2 is an exemplary diagram that illustrates the values stored in each determination latch. Here, the determination latches corresponding to the ways #0 to #7 are the determination latches 60, 61, 62, 63, 64, 65, 66, and 67.

For, for example, the determination latch 61 that corresponds to the way #1, the expected value matches the data read from the memory address corresponding to the way #1, as illustrated in a column 11. Therefore, the determination latch 61 is held at "L", as illustrated in a column 12. Specifically, as illustrated in a column 13, the status of the way #1 is "good". Conversely, for the determination latch 66 that corresponds to the way #6, the expected value does not match the data read from the memory address corresponding to the way #6, as illustrated in a column 14. Therefore, the determination latch 66 is held at "H", as illustrated in a column 15. Specifically, as illustrated in a column 16, the status of the way #6 is "faulty". As described above, the status of a corresponding way can be determined on the basis of the value held by the determination latch 60 to 67.

The OR circuit 7 illustrated in FIG. 1 receives an input of the value held by the FF 603 in each of the determination latches 60 to 67. The OR circuit 7 then performs a logical OR operation on the received value and outputs the obtained value to the start-marker 8. For example, if data read from any one of the ways #0 to #7 is different from an expected value, the OR circuit 7 receives "H" from one of the FFs 603 in the determination latches 60 to 67. In this case, the OR circuit 7 performs a logical OR operation so as to obtain "H". Thus, if data read from any one of the ways #0 to #7 is different from an expected value, the OR circuit 7 outputs "H" to the start-marker 8.

The start-marker 8 is a flip-flop. The start-marker 8 holds the value received from the OR circuit 7. Specifically, if data read from any one of the ways #0 to #7 is different from an expected value, the start-marker 8 is held at "H". Conversely, if data read from all of the ways #0 to #7 matches an expected value, the start-marker 8 is held at "L".

The tester 101 sends setting information for a test pattern to the RAM-BIST pattern generating unit 1 according to a scan clock so as to perform a scan-in for test settings. The tester 101 applies a system clock to the RAM-BIST pattern generating unit 1, the L2 cache 2, the determination latches 60 to 67, and the FFs 91, 92, whereby a test is carried out.

After the test ends, the tester 101 serially reads the values of the start-marker 8 and the FF 603 in each of the determination latches 60 to 67 so as to perform a scan-out. Specifically, the tester 101 reads the values, starting from the value of the start-marker 8, the determination latches 67, 66, 65, 64, 63, 62, 61, and then the determination latch 60.

Next, the tester 101 specifies a way where a failure occurs on the basis of the position of the read value "H". For example, if there is a faulty way, the tester 101 reads "H" from the start-marker 8. The tester 101 determines that the first "H" read during the scan-out is the value read from the start-marker 8. The tester 101 then determines how far apart the first read "H" and the next "H" are, thereby specifying a faulty way on the basis of the distance. For example, in the case illustrated in FIG. 1, if the next "H" comes after the first read "H" and subsequent six "L"s, the tester 101 determines that the way #6 is faulty.

The tester 101 pre-stores therein a threshold (e.g., the number of ways) as an acceptable average value. The tester 101 calculates the number of faulty ways in accordance with the result of determining faulty ways. If the number of faulty ways is less than a pre-stored threshold, the tester 101 determines that the L2 cache 2 is allowed to be shipped. If the number of faulty ways is equal to or greater than the threshold, the tester 101 determines that the L2 cache 2 is not allowed to be shipped. For example, if the number of faulty ways is less than 2, the tester 101 determines that the L2 cache 2 is allowed to be shipped. If the number of faulty ways is equal to or greater than 2, the tester 101 determines that the L2 cache 2 is not allowed to be shipped. If it is determined that the L2 cache 2 is allowed to be shipped although a faulty way is present, the L2 cache 2 can be shipped, for example, with the detected faulty way degenerated and not operating.

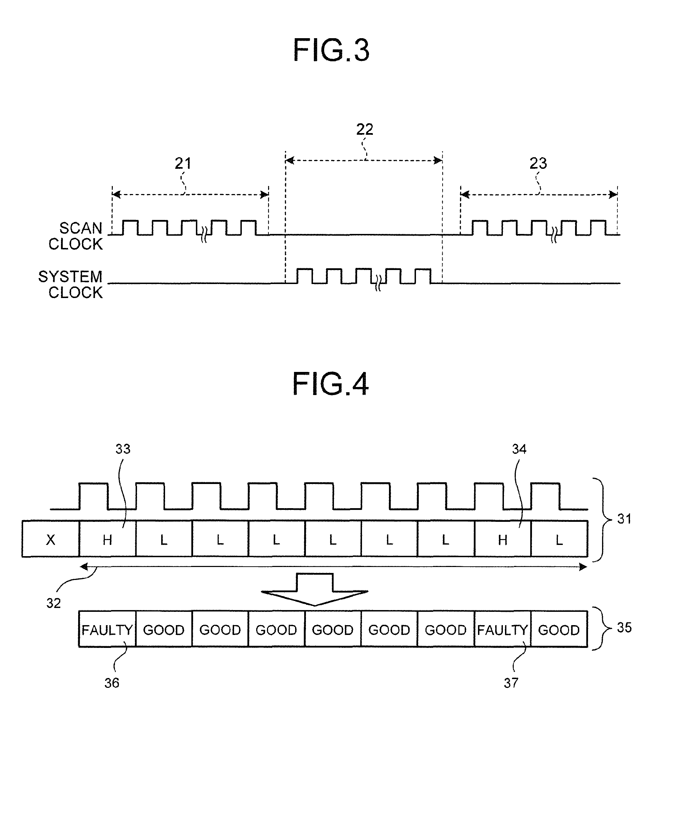

Next, an explanation is given of scan and test timings with reference to FIG. 3. FIG. 3 is a timing chart of scans and tests. The upper section of FIG. 3 illustrates a scan clock, and the lower section thereof illustrates a system clock.

The tester 101 performs a scan-in during a time period 21. Specifically, the tester 101 sends setting information for a test pattern to the RAM-BIST pattern generating unit 1 during the time period 21 by using a scan clock.

Next, during a time period 22, the semiconductor device 100 operates according to a system clock that is generated on the basis of an external input clock input from the tester 101. The semiconductor device 100 then performs a test in accordance with the test settings by using a system clock. Due to the application of system clocks, the RAM-BIST pattern generating unit 1 generates a RAM test pattern, such as a March, in accordance with the program that is set during the time period 21. The L2 cache 2 is tested by using the RAM test pattern generated by the RAM-BIST pattern generating unit 1.

The tester 101 performs a scan-out during a time period 23. Specifically, the tester 101 serially reads the values of the start-marker 8 and the FF 603 in each of the determination latches 60 to 67 by using a scan clock during the time period 23. Afterward, the tester 101 uses the read result to determine the quality of each way in the memory and to determine whether the L2 cache is allowed to be shipped.

FIG. 4 is a diagram that illustrates the details of information reading. The upper section of representation 31 in FIG. 4 represents a scan clock, and the lower section thereof represents the values of the determination latches, starting with the value of the start-marker 8.

A time period 32 in the representation 31 is an L-expected section. Specifically, during the time period 32, the tester 101 expects that the value "L" is input as a normal value and, if "H" is input, determines that a failure occurs.

In the time period 23 illustrated in FIG. 3, the tester 101 reads the values in synchronization with a scan timing, starting from the start-marker 8, the determination latches 67, 66, 65, 64, 63, 62, 61, and then the determination latch 60, as illustrated in the representation 31. If the value "H" is input in the lead, the tester 101 determines that it is the value of the start-marker 8.

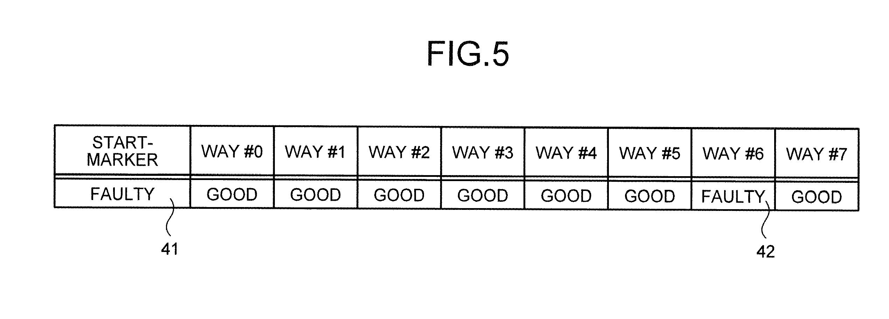

As illustrated in FIG. 4, for example, the tester 101 reads the leading "H" at a read value 33 and reads "H" at a read value 34. In this case, the tester 101 can determine the quality of a way on the basis of the acquired value, as illustrated in representation 35. Here, status 36 indicates the status of the start-marker 8, and status 37 indicates that a failure occurs in any one of the ways #0 to #7. First, the tester 101 determines that the status 36 is faulty so as to recognize that a faulty point is present in the following 8 statuses. The tester 101 then specifies a faulty way on the basis of the position of the status 37 relative to the status 36. FIG. 5 is a diagram that illustrates the relation between each way and the status of each way determined by the tester. When the tester 101 determines the status of each way as illustrated in FIG. 4, the determined status is arranged in sequence as in the lower section of FIG. 5. Status 41 indicating the first failure read by the tester 101 corresponds to the start-marker, and it indicates that any of the ways #0 to #7 in the memory is faulty. The tester 101 determines that a failure has occurred in a status 42 that is located after the status 41 with 6 good statuses interposed therebetween. The status 42 after the status 41 with 6 good statues interposed therebetween corresponds to the way #6. Thus, the tester 101 determines that the way #6 is faulty. FIGS. 4 and 5 illustrate the state where a single way is faulty; however, if multiple ways are faulty, the value of the start-marker 8 in the lead is also "H" and therefore the tester 101 can determine that the leading value "H" is the value of the start-marker 8. Furthermore, the tester 101 can specify a faulty way on the basis of the position of "H" received during a subsequent L-expected section.

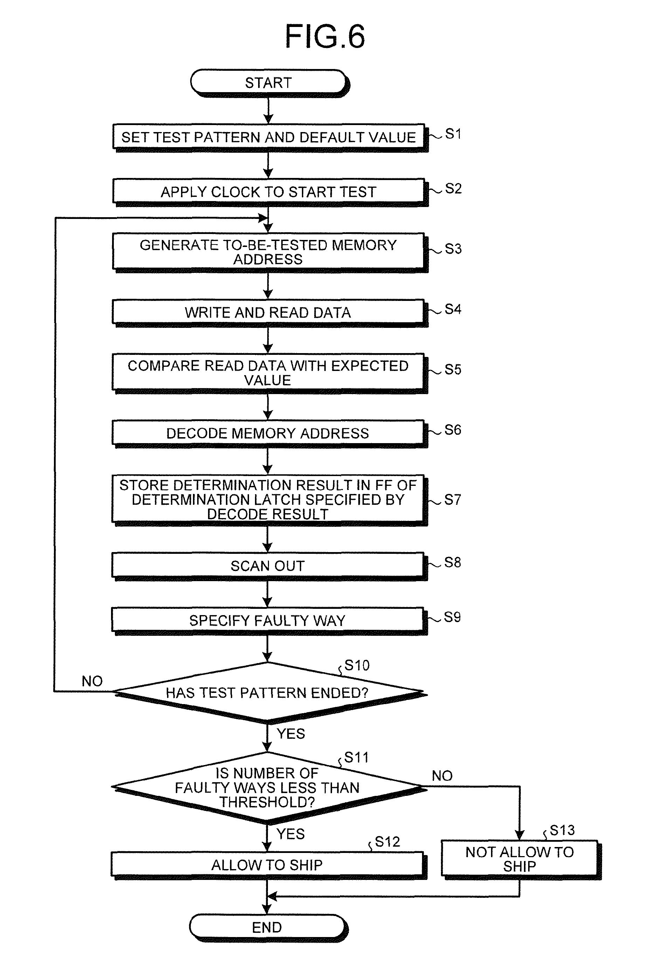

Next, an explanation is given of the flow of a test performed by the semiconductor device according to the present embodiment. FIG. 6 is a flowchart of a test performed by the semiconductor device according to the present embodiment.

The tester 101 sends a default value of setting information for a test pattern, or the like, to the RAM-BIST pattern generating unit 1 so as to set a memory test (Step S1).

The tester 101 applies a system clock to each unit of the semiconductor device 100, such as the RAM-BIST pattern generating unit 1, whereby a test is started (Step S2).

The RAM-BIST pattern generating unit 1 generates a to-be-tested memory address, write data to the RAM, and an expected value in accordance with the test pattern (Step S3).

The L2 cache 2 receives the to-be-tested memory address from the RAM-BIST pattern generating unit 1. The L2 cache 2 then writes data output from the RAM-BIST pattern generating unit 1 to the designated to-be-tested memory address. The L2 cache 2 then reads data from the to-be-tested memory address (Step S4).

The XOR circuit 3 receives an input of the data read by the L2 cache 2 and the expected value output from the RAM-BIST pattern generating unit 1. The XOR circuit 3 compares the data read from the to-be-tested memory address with the expected value (Step S5). Specifically, the XOR circuit 3 performs an exclusive OR operation on the data read from the to-be-tested memory address and the expected value.

The decode unit 5 decodes the to-be-tested memory address output from the RAM-BIST pattern generating unit 1 and then outputs to the determination latch 60 to 67 (Step S6). Specifically, the decode unit 5 outputs, to a determination latch that corresponds to the to-be-tested memory address, the same value as that output from the XOR circuit 3 when the read data does not match the expected value.

The determination latch 60 to 67, which the decode unit 5 determines corresponds to the to-be-tested memory address, stores a determination result of the read data and the expected value in the FF 603 (Step S7).

The tester 101 serially reads the values stored in the start-marker 8 and the FF 603 of the determination latches 60 to 67 for a scan-out (Step S8).

The tester 101 specifies a faulty way on the basis of a read data sequence (Step S9).

The tester 101 determines whether the test pattern has ended (Step S10). If the test pattern has not ended (Step S10: No), the tester 101 returns to Step S3.

Conversely, if the test pattern has ended (Step S10: Yes), the tester 101 determines whether the number of faulty ways is less than a threshold (Step S11). If the number of faulty ways is less than a threshold (Step S11: Yes), the tester 101 determines that the L2 cache 2 is allowed to be shipped (Step S12).

Conversely, if the number of faulty ways is equal to or greater than a threshold (Step S11: No), the tester 101 determines that the L2 cache 2 is not allowed to be shipped (Step S13).

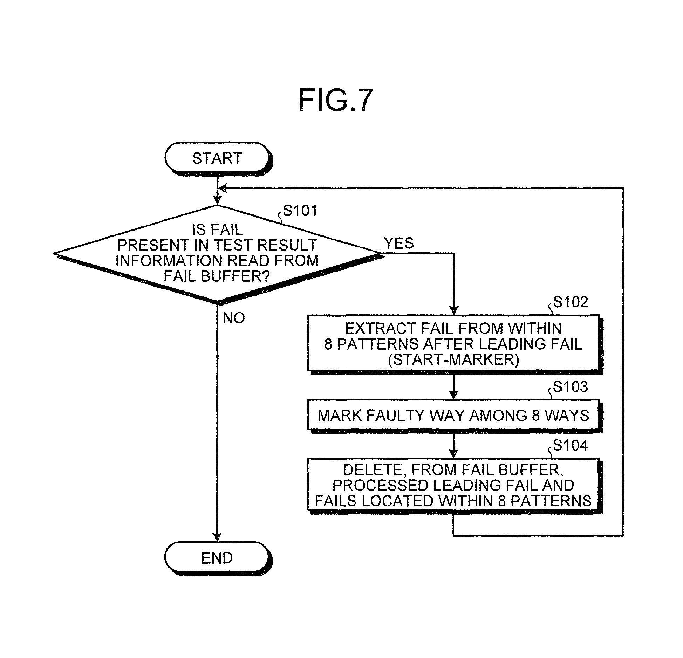

Next, an explanation is given, with reference to FIG. 7, of a process performed by the tester 101 to determine a faulty way according to the present embodiment. FIG. 7 is a flowchart of a process to determine a faulty way.

Here, the fail buffer illustrated in FIG. 7 is a buffer that is included in the tester 101 to store a test result of a RAM-BIST, the test result being output from the semiconductor device 100 when the tester 101 performs a scan-out. The fail buffer is not illustrated in FIG. 1.

The tester 101 sequentially reads a test result of the RAM-BIST that is stored in the fail buffer. The tester 101 then determines whether the read test result is "H" or not so as to determine whether a fail has occurred (Step S101). Specifically, if a test result is "H", the tester 101 determines that a fail is present.

If a fail is present (Step S101: Yes), the tester 101 determines that the leading fail, which is found first, to be a start-marker. The tester 101 then extracts a fail from within 8 patterns after the leading fail (the start-marker), i.e., 8 test results subsequent to the start-marker (Step S102).

Next, the tester 101 uses the position of the extracted fail relative to the start-marker so as to specify a way where a fail occurs and then marks the faulty way among the 8 ways so that the specified way can be distinguished (Step S103).

The tester 101 then deletes, from the fail buffer, the processed leading fail and the fail located within 8 patterns after the leading fail (Step S104). Afterward, the tester 101 returns to Step S101.

Conversely, if a fail is not present in the fail buffer (Step S101: No), the tester 101 terminates the faulty way determination.

The above explanation is given of a case where there is a single memory; however, multiple memories may be provided. In such a case, every memory is provided with the XOR circuit 3, the decode unit 5, the determination latches 60 to 67, the OR circuit 7, the start-marker 8, and the FFs 91, 92. The tester 101 serially reads the values stored in the start-marker 8 and the FFs 603 of the determination latches 60 to 67, which correspond to each memory.

In the above case, the tester 101 determines that the first "H" in a sequence of read values is the value of the start-marker 8 in any one of the memories and specifies a faulty way by using "H" within subsequent 8 values. Next, the tester 101 determines that the first "H" in a sequence of values, which follows after the value of the start-marker 8 and the subsequent 8 values, is the value of the start-marker 8 in any one of the memories and specifies a faulty way by using "H" within subsequent 8 values. In this case, it is difficult for the tester 101 to specify which memory includes a faulty way; however, a faulty way can be specified. Thus, the tester 101 can acquire information about which way is faulty and can determine the number of faulty ways on the basis of information about faulty ways.

### Hardware Configuration

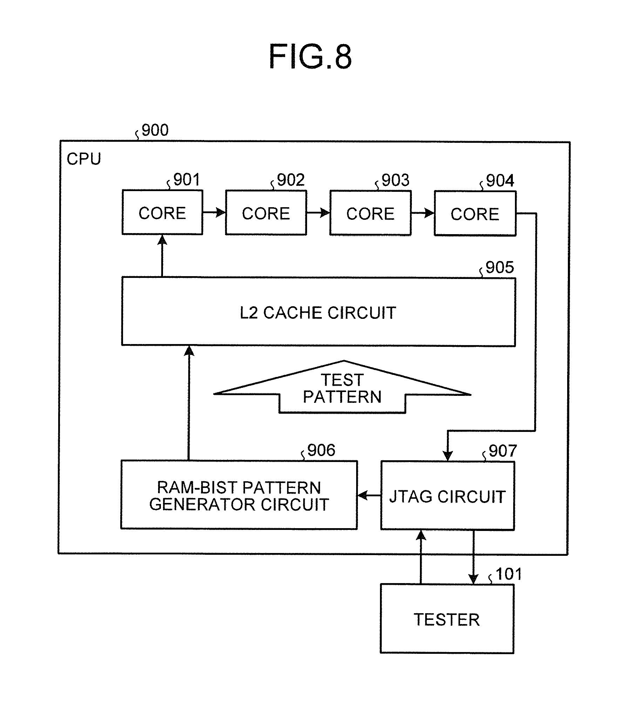

FIG. 8 is a hardware configuration diagram of a CPU in which a semiconductor device according to the embodiment is installed.

As illustrated in FIG. 8, a CPU 900 includes cores 901 to 904, an L2 cache circuit 905, an RAM-BIST pattern generator circuit 906, and a Joint Test Action Group (JTAG) circuit 907.

The JTAG circuit 907 accesses test circuits that are installed within the L2 cache circuit 905, the cores 901 to 904, and the like, so as to control the state of terminals or communicate with internal circuits.

The tester 101 performs a scan-in on the RAM-BIST pattern generator circuit 906, or the like, via the JTAG circuit 907. Furthermore, the tester 101 performs a scan-out via the JTAG circuit 907. The tester 101 establishes a scan path, starting from the JTAG circuit 907, the RAM-BIST pattern generator circuit 906, the L2 cache circuit 905, the cores 901 to 904, and then the JTAG circuit 907. The scan path is obtained by linking together the FFs installed in the cores 901 to 904 and the L2 cache circuit 905.

A single scan path is illustrated in FIG. 8; however, a scan path may be divided depending on the circuit size of the cores 901 to 904, the L2 cache circuit 905, or the like, and a RAM-BIST result may be read by using any one of the divided scan paths.

The RAM-BIST pattern generator circuit 906 performs the functionality of, for example, the RAM-BIST pattern generating unit 1 illustrated in FIG. 1. The RAM-BIST pattern generator circuit 906 sends a test pattern to the L2 cache circuit 905.

For example, the L2 cache 2 illustrated in FIG. 1 is installed in the L2 cache circuit 905. Furthermore, the L2 cache circuit 905 performs the functionality of the XOR circuit 3, the decode unit 5, the determination latches 60 to 67, the OR circuit 7, the start-marker 8, the FFs 91, 92, and the like.

The cores 901 to 904 perform calculation operations.

As described above, a semiconductor device according to the present embodiment can determine the quality of each way included in a memory by performing a single RAM-BIST. Thus, it is possible to conduct a test on a semiconductor in a short time.

According to an aspect of a semiconductor device and a memory test method that are disclosed in the present application, it is possible to conduct a test on a memory in a shorter period of time.

## Claims

1. A semiconductor device comprising:
a memory (2) that is used by dividing an address range into sets of a predetermined number of ways;
a test information generating unit (1) that, in order to test the memory (2), generates a memory address corresponding to the way, a test pattern, and an expected value with respect to the test pattern;
a quality determination testing unit (3) that, in accordance with the test pattern, writes the test pattern to the memory address generated by the test information generating unit (1), reads data from the memory address to which the test pattern is written, and compares the read data with the expected value;
a selection signal generating unit (5) that generates a selection signal for each way of the memory (2) by using the memory address generated by the test information generating unit (1); and
a first storage unit (60 to 67) that stores, by using the selection signal and in the way corresponding to each memory address, a comparison result obtained by the quality determination testing unit (3) with respect to the memory address, a scan-out being performed on the comparison result stored in each of the ways in a predetermined order.

2. The semiconductor device according to claim 1, wherein the quality determination testing unit (3) compares the read data with the expected value and, when the read data is different from the expected value, determines a way to be faulty.

3. The semiconductor device according to claim 1 or 2, further comprising a second storage unit (8) that stores a value indicating whether a faulty way is present or not in accordance with the comparison result of each of the ways, the value stored in the second storage unit (8) being read just before the comparison results stored in the first storage unit (60 to 67) are read during the scan-out.

4. The semiconductor device according to any one of claims 1 to 3, wherein
the memory (2) includes multiple memories, and
the comparison results stored in the first storage unit (60 to 67) of the multiple memories are sequentially read.

5. A memory test method comprising:
generating, in order to test a memory that is used by dividing an address range into sets of a predetermined number of ways, a memory address corresponding to the way, a test pattern, and an expected value with respect to the test pattern;
in accordance with the test pattern, writing the test pattern to the memory address generated, reading data from the memory address to which the test pattern is written, and comparing the read data with the expected value;
generating a selection signal for each way of the memory by using the memory address generated;
storing, by using the selection signal and in the way corresponding to each memory address, a comparison result with respect to the memory address;
reading the comparison result stored in each of the ways in a predetermined order; and
specifying a faulty way in accordance with the read comparison result.

6. The memory test method according to claim 5, further comprising:
before reading the comparison result of each of the ways, reading a value indicating whether a faulty way is present or not; and
by using the read value indicating whether a faulty way is present or not and a subsequent sequence of the comparison results, specifying a faulty way in accordance with a position of the read comparison result relative to the value indicating whether a faulty way is present or not.
